(19) Europäisches Patentamt / European Patent Office / Office européen des brevets

(11) **EP 1 941 291 B1**

(12) **FASCICULE DE BREVET EUROPEEN**

(45) Date de publication et mention de la délivrance du brevet:
**08.04.2009 Bulletin 2009/15**

(51) Int Cl.:
*G01R 33/12* *(2006.01)*        *H01F 10/00* *(2006.01)*

(21) Numéro de dépôt: **06819106.3**

(86) Numéro de dépôt international:
**PCT/EP2006/067601**

(22) Date de dépôt: **20.10.2006**

(87) Numéro de publication internationale:
**WO 2007/048752 (03.05.2007 Gazette 2007/18)**

(54) **PROCEDE DE MESURE DE PERMEABILITE MAGNETIQUE ET ECHANTILLON DE REFERENCE UTILISE DANS CELUI-CI**

MESSVERFAHREN FÜR DIE MAGNETISCHE PERMEABILITÄT UND DAFÜR VERWENDETE BEZUGSPROBE

MAGNETIC PERMEABILITY MEASURING METHOD AND A REFERENCE SAMPLE USED THEREFOR

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **24.10.2005  FR 0553223**

(43) Date de publication de la demande:
**09.07.2008  Bulletin 2008/28**

(73) Titulaire: **COMMISSARIAT A L'ENERGIE ATOMIQUE**
**75015 Paris (FR)**

(72) Inventeurs:
• **LEDIEU, Marc**
  **F-37510 Ballan Mire (FR)**
• **ACHER, Olivier**
  **F-37260 Monts (FR)**

(74) Mandataire: **Ilgart, Jean-Christophe et al**
**BREVALEX**
**3, rue du Docteur Lancereaux**
**75008 Paris (FR)**

(56) Documents cités:
FR-A- 2 699 683        FR-A- 2 822 957
US-A- 5 103 173        US-A- 5 744 972
US-B1- 6 351 119

• LEDIEU M ET AL: "New achievements in high-frequency permeability measurements of magnetic materials" JOURNAL OF MAGNETISM AND MAGNETIC MATERIALS, ELSEVIER, AMSTERDAM, NL, vol. 258-259, mars 2003 (2003-03), pages 144-150, XP004413819 ISSN: 0304-8853
• JACQUART P-M ET AL: "Influence of the electrical resistivity of a ferromagnetic thin film on its permeability measurement performed with a permeameter" JOURNAL OF MAGNETISM AND MAGNETIC MATERIALS, ELSEVIER SCIENCE PUBLISHERS, AMSTERDAM, NL, vol. 281, no. 1, octobre 2004 (2004-10), pages 82-91, XP004568407 ISSN: 0304-8853
• DRAKE A E ET AL: "REFERENCE MATERIALS FOR CALIBRATING MAGNETIC PERMEABILITY MEASURING EQUIPMENT" IEEE TRANSACTIONS ON MAGNETICS, IEEE SERVICE CENTER, NEW YORK, NY, US, vol. 26, no. 5, 1 septembre 1990 (1990-09-01), pages 2050-2051, XP000109147 ISSN: 0018-9464
• SENDA M ET AL: "PERMEABILITY MEASUREMENT IN THE GHZ RANGE FOR SOFT-MAGNETIC FILM USING THE M/C/M INDUCTANCE-LINE" IEEE TRANSACTIONS ON MAGNETICS, IEEE SERVICE CENTER, NEW YORK, NY, US, vol. 31, no. 2, mars 1995 (1995-03), pages 960-965, XP000867105 ISSN: 0018-9464

- PAIN D ET AL: "An improved permeameter for thin film measurements up to 6 GHz" JOURNAL OF APPLIED PHYSICS, AMERICAN INSTITUTE OF PHYSICS. NEW YORK, US, vol. 85, no. 8, 15 avril 1999 (1999-04-15), pages 5151-5153, XP012047376 ISSN: 0021-8979 cité dans la demande
- YAMAGUCHI M ET AL: "Cross measurements of thin-film permeability up to UHF range" JOURNAL OF MAGNETISM AND MAGNETIC MATERIALS, ELSEVIER, AMSTERDAM, NL, vol. 242-245, avril 2002 (2002-04), pages 970-972, XP004360802 ISSN: 0304-8853 cité dans la demande
- ADENOT A-L ET AL: "Broadband permeability measurement of ferromagnetic thin films or microwires by a coaxial line perturbation method" JOURNAL OF APPLIED PHYSICS, AMERICAN INSTITUTE OF PHYSICS. NEW YORK, US, vol. 87, no. 9, 1 mai 2000 (2000-05-01), pages 5965-5967, XP012050372 ISSN: 0021-8979
- ACHER O ET AL: "PERMEABILITY MEASUREMENT ON FERROMAGNETIC THIN FILMS FROM 50 MHZ UP TO 18 GHZ" JOURNAL OF MAGNETISM AND MAGNETIC MATERIALS, ELSEVIER SCIENCE PUBLISHERS, AMSTERDAM, NL, vol. 136, no. 3, 2 septembre 1994 (1994-09-02), pages 269-278, XP000467093 ISSN: 0304-8853
- FESSANT A ET AL: "A BROAD-BAND METHOD FOR MEASURING THE COMPLEX PERMEABILITY OF THIN SOFT MAGNETIC FILMS" JOURNAL OF MAGNETISM AND MAGNETIC MATERIALS, ELSEVIER SCIENCE PUBLISHERS, AMSTERDAM, NL, vol. 133, no. 1/3, 1 mai 1994 (1994-05-01), pages 413-415, XP000443717 ISSN: 0304-8853
- SENDA M: "PERMEABILITY MEASUREMENT OF SOFT MAGNETIC FILMS AT HIGH FREQUENCY AND MULTILAYERING EFFECT" IEEE TRANSLATION JOURNAL ON MAGNETICS IN JAPAN, IEEE INC, NEW YORK, US, vol. 8, no. 3, 1 mars 1993 (1993-03-01), pages 161-168, XP000362059 ISSN: 0882-4959

**Description**

DOMAINE TECHNIQUE

L'invention concerne un procédé de mesure de perméabilité magnétique et un échantillon de référence magnétique utilisé dans celui-ci.

ÉTAT DE LA TECHNIQUE ANTÉRIEURE

Les propriétés électromagnétiques des matériaux (permittivité diélectrique et perméabilité magnétique) sont très intéressantes à connaître du fait notamment des développements toujours plus rapides dans le domaine des télécommunications. Ces matériaux sont en effet intégrés dans bon nombre de systèmes (antennes, filtres,...) ou de composants électroniques (inductances, lignes de transmission,...) dont les performances dépendent des propriétés des matériaux utilisés dans des bandes de fréquence se situant du continu à plusieurs dizaines de GHz.

Pour caractériser les propriétés électromagnétiques d'un matériau, que ce soit en structure guidée ou en espace libre, on mesure l'interaction d'un champ électromagnétique avec ce matériau. Une modélisation ou un calcul analytique permet alors de remonter aux spectres de propriétés électromagnétiques du matériau (permittivité diélectrique et perméabilité magnétique). Ce matériau peut être préparé sous la forme d'un échantillon adapté à une technique de caractérisation, ou caractérisé dans son environnement d'utilisation (contrôle non destructif par exemple).

Les techniques de caractérisation hyperfréquence d'un matériau peuvent être regroupées en trois grandes catégories :

- les techniques temporelles basées sur l'analyse spectrale de Fourier de l'interaction d'une impulsion ultracourte avec le matériau ;
- les techniques harmoniques absolues: aucun coefficient de calibrage n'est nécessaire pour calculer les spectres de propriétés à partir des mesures de l'interaction onde / matériau ;
- les techniques harmoniques non absolues: un coefficient correctif est nécessaire pour ajuster le calcul et disposer au final de valeurs de propriétés radioélectriques absolues, un exemple par perturbation de spire étant ainsi décrit dans le document référencé [1] en fin de description.

En terme de métrologie, trois aspects sont à prendre en compte:

- l'étalonnage/calibrage de l'instrumentation de mesure (valable quelle que soit la technique utiliséé);
- la détermination des coefficients correctifs pour le calcul des propriétés absolues d'un matériau, dans le cas des techniques harmoniques non absolues;
- la vérification de la non dérive d'une instrumentation ou de la validité de la chaîne de calcul associée (valable quelle que soit la technique utilisée).

Lorsque l'on utilise un analyseur de réseaux vectoriel, qui permet la mesure de l'interaction d'un matériau avec une onde électromagnétique en quantifiant la transmission et la réflexion de celui-ci à travers ou sur l'échantillon utilisé, pour étalonner celui-ci on réalise classiquement une comparaison avec un dispositif relié à un étalon de temps et de fréquence. Cet analyseur est ensuite calibré pour compenser les différentes sources d'erreurs dans la mesure des paramètres de transmission et de réflexion de l'onde, en utilisant des charges connues (impédances de référence). Un calcul permet de déterminer des coefficients de correction à appliquer systématiquement aux mesures. Ces charges connues peuvent être des éléments passifs et mécaniques ou des dispositifs électroniques qui viennent automatiquement présenter à l'analyseur des charges différentes.

Il peut être nécessaire, également, de déterminer les coefficients correctifs pour le calcul des niveaux absolus de propriétés des échantillons et de vérifier la non dérive des performances des dispositifs. Ces étapes, pour les propriétés diélectriques (permittivité), sont traditionnellement réalisées à l'aide de matériaux de référence de permittivité, par exemple des céramiques oxydes, pour réaliser des permittivités différentes. On réalise alors des échantillons dits de référence qui sont utilisés pour déterminer les coefficients correctifs ou vérifier que l'instrumentation donne bien les valeurs que l'on attend. Dans le cas des faibles valeurs de permittivité, on peut utiliser des polymères (exemple du Plexiglas de permittivité $\varepsilon \approx 2{,}72$). Ces polymères sont moins satisfaisants en terme de stabilité dans le temps et en température avec une température de transition vitreuse faible, souvent inférieure à 100°C. Des circuits d'inter-comparaisons, mis en place en parallèle, permettent de déterminer les valeurs de permittivité des matériaux utilisés comme référence.

Dans le cas de la caractérisation de matériaux magnétiques, on peut utiliser des échantillons de référence de ferrite. De géométrie stable dans le temps (céramique), ces échantillons magnétiques sont néanmoins très sensibles au champ magnétique extérieur et sensibles aux variations de température. Dans le domaine de la caractérisation des couches minces ferromagnétiques des inter-comparaisons sur des échantillons ont été réalisées, par exemple dans des mesures comparatives telles que décrites dans le document référencé [2].

Les échantillons peuvent être re-découpés pour pouvoir s'adapter aux différentes techniques de caractérisation. Ceci entraîne des modifications de leur taille, et de leur réponse au champ électromagnétique (effets démagnétisants statiques et dynamiques). Avec des couches minces de grande dimension, les dispositifs de caractérisation utilisent des champs localisés. La surface de ces couches n'est plus alors excitée de façon homogène et leurs propriétés apparentes en sont modifiées. Les matériaux magnétiques présentent par ailleurs un hystérésis magnétique qui ne permet pas, a priori, de garantir l'état magnétique et donc le spectre de perméabilité d'un matériau. Cela impose un respect strict de procédures de conditionnement magnétique de l'échantillon pour disposer d'une référence.

On ne dispose donc pas aujourd'hui d'échantillons de référence fiables permettant, a minima, les vérifications métrologiques évoquées plus haut.

Le document référencé [1] décrit un système de mesure de perméabilité composé d'une cellule de mesure, qui est une mono-spire, associée à un analyseur de réseau vectoriel qui permet la mesure de l'impédance de la cellule de mesure. Un traitement mathématique permet de calculer le spectre de perméabilité à partir de la différence d'impédance mesurée avec et sans le matériau magnétique dans la cellule de mesure. Pour réaliser le calcul, on dispose de trois information les paramètres de modélisation de la cellule de mesure, un coefficient correctif K et le volume de matériau magnétique introduit dans la cellule. Les paramètres de la cellule sont obtenus à partir d'une mesure de celle-ci a l'aide de l'analyseur. Le volume de matière magnétique est entré par l'opérateur. Le coefficient K est obtenu en mesurant un échantillon magnétique connu et en ajustant ce coefficient K pour faire coïncider données expérimentales et valeurs de référence.

Le document référencé [2] décrit la mesure comparée de la perméabilité de couches minces jusqu'à la gamme de fréquences UHF. Ce document montre que la procédure de validation des mesures est une procédure très lourde.

Dans ces deux documents se pose le problème technique de détermination de la valeur du coefficient correctif K et sa vérification au cours du temps. La perméabilité d'un matériau magnétique dépend de l'environnement électromagnétique, de la contrainte appliquée, de la température, de l'oxydation... . Le matériau magnétique doit donc être utilisé avec beaucoup de précautions comme référence et sa stabilité dans le temps n'est pas assurée.

Le document <<LEDIEU M ET AL: "New achievements in high-frequency permeability measurements of magnetic materials" JOURNAL OF MAGNETISM AND MAGNETIC MATERIALS, ELSEVIER, AMSTERDAM, NL, vol. 258-259, mars 2003 (2003-03), pages 144-150, XP004413819 ISSN: 0304-8853p décrit un procédé de mesure de la perméabilité magnétique d'un matériau magnétique par mesure de l'interaction magnétique d'un champ électromagnétique avec ce matériau en utilisant un dispositif de mesure comportant une cellule de mesure reliée par un câble hyperfréquence à un analyseur de réseau vectoriel, ledit procédé comprenant des étapes préalables d'étalonnage/calibrage dudit dispositif de mesure, de détermination de coefficients correctifs à appliquer aux mesures obtenues grâce à ce dispositif, et de vérification de la non dérive de ce dispositif,

ces étapes étant réalisées à l'aide d'un échantillon de référence, et une étape de mesure de la perméabilité du matériau magnétique.

En plus, ledit document divulgue ainsi un échantillon de référence de perméabilité apte à être utilisé pour des étapes d'étalonnage/calibrage d'un dispositif de mesure de la perméabilité magnétique d'un matériau magnétique par mesure de l'interaction magnétique d'un champ électromagnétique avec ce matériau, ce dispositif de mesure comportant une cellule de mesure reliée par un câble hyperfréquence à un analyseur de réseau vectoriel, de détermination des coefficients correctifs à appliquer aux mesures obtenues grâce à ce dispositif, et de vérification de la non-dérive de ce dispositif.

Autres documents pertinents sont FR-A-2 822 957, US-B1-6 351 119 et <<JACQUART P-M ET AL: "Influence of the electrical resistivity of a ferromagnetic thin film on its permeability measurement performed with a permeameter" JOURNAL OF MAGNETISM AND MAGNETIC MATERIALS, ELSEVIER SCIENCE PUBLISHERS, AMSTERDAM, NL, vol. 281, no. 1, octobre 2004 (2004-10), pages 82-91, XP004568407 ISSN: 0304-8853.

L'invention a pour objet de proposer un procédé de mesure de perméabilité magnétique et un échantillon de référence utilisé dans celui-ci permettant le réglage et la vérification de ce système.

EXPOSÉ DE L'INVENTION

L'invention concerne un procédé de mesure de la perméabilité magnétique d'un matériau magnétique par mesure de l'interaction magnétique d'un champ électromagnétique avec ce matériau en utilisant un dispositif de mesure comportant une cellule de mesure reliée par un câble hyperfréquence à un analyseur de réseau vectoriel, ledit procédé comprenant des étape préalables :

- d'étalonnage/calibrage dudit dispositif de mesure,
- de détermination de coefficients correctifs à appliquer aux mesures obtenues grâce à ce dispositif,
- de vérification de la non-dérive de ce dispositif,

ces étapes étant réalisées à l'aide d'un échantillon de référence, une étape de mesure de la pérméabilité du matériau magnétique,
**caractérisé en ce que** pendant des étapes préalables on utilise un échantillon de référence comprenant au moins une inclusion permettant de créer, dans un volume donné, une perméabilité artificielle locale, chaque inclusion étant réalisée par la combinaison d'au moins un composant inductif éventuellement associé à une combinaison d'au moins un composant capacitif, et/ou résistif, et/ou actif, la réponse en fréquence des propriétés électromagnétiques de chaque volume étant ajustée par la valeur et l'architecture d'assemblage des composants, et en ce que le valeur d'au moins un composant d'au moins une inclusion est ajustable à distance.

L'invention concerne également un échantillon de référence de perméabilité apte à être utilisé pour :

- l'étalonnage/calibrage d'un dispositif de mesure de la perméabilité magnétique d'un matériau magnétique par mesure de l'interaction magnétique d'un champ électromagnétique avec ce matériau, ce dispositif de mesure comportant une cellule de mesure reliée par un câble hyperfréquence à un analyseur de réseau vectoriel,
- la détermination des coefficients correctifs à appliquer aux mesures obtenues grâce à ce dispositif,
- la vérification de la non-dérive de ce dispositif,

**caractérisé en ce qu**'il comprend au moins une inclusion permettant de créer, dans un volume donné, une perméabilité artificielle locale, chaque inclusion étant réalisée par la combinaison d'au moins un composant inductif éventuellement associé à une combinaison d'au moins un composant capacitif, et/ou résistif, et/ou actif, la réponse en fréquence des propriétés électromagnétiques de chaque volume étant ajustée par la valeur et l'architecture d'assemblage des composants, et en ce que la valeur d'au moins un composant d'an moins une inclusion est ajustable à distance.

Avantageusement l'échantillon de référence comporte au moins un élément contenant un matériau magnétique.

Avantageusement la valeur d'au moins un composant d'au moins une inclusion est ajustable à distance. Au moins un composant comprend des éléments à fonction électrique.

Dans le cas où le composant inductif comprend un noyau magnétique, on préférera que sa valeur soit plutôt donnée par ses caractéristiques géométriques que par la valeur de la perméabilité intrinsèque du noyau, par le principe bien connu des noyaux à entrefer.

Avantageusement, les composants d'au moins une inclusion sont enrobés dans un matériau diélectrique de remplissage. C'est également l'ensemble des inclusions qui peut être maintenu en forme par un matériau diélectrique de remplissage. Cela peut permettre un positionnement répétable et facile dans une cellule de mesure.

Avantageusement l'échantillon de référence présente une fonction magnétique de référence dans une direction de champ électromagnétique, et une fonction diélectrique non magnétique dans une autre direction.

Avantageusement, à l'échantillon, peut être associée une valeur de fonction magnétique de référence qui peut, par exemple, être la perméabilité, la perméance, ou une valeur intégrale de la perméabilité en fréquence.

BRÈVE DESCRIPTION DES DESSINS

La figure 1 illustre un dispositif mettant en oeuvre le procédé de mesure de perméabilité magnétique de l'invention.

La figure 2 illustre un exemple de réalisation de l'échantillon de référence de l'invention.

Les figures 3, 4, 5A et 5B illustrent des spectres de perméance obtenus sur des échantillons de référence à partir de trois éléments R, L et C en parallèle.

La figure 6 illustre le principe de réalisation d'un échantillon de référence magnétique avec une référence diélectrique intégrée

Les figures 7A et 7B illustrent le positionnement d'un échantillon bipolarisé dans des vues de dessus, respectivement pour la mesure sur la partie diélectrique et pour la mesure de la perméabilité de référence.

EXPOSÉ DÉTAILLÉ DE MODES DE RÉALISATION PARTICULIERS

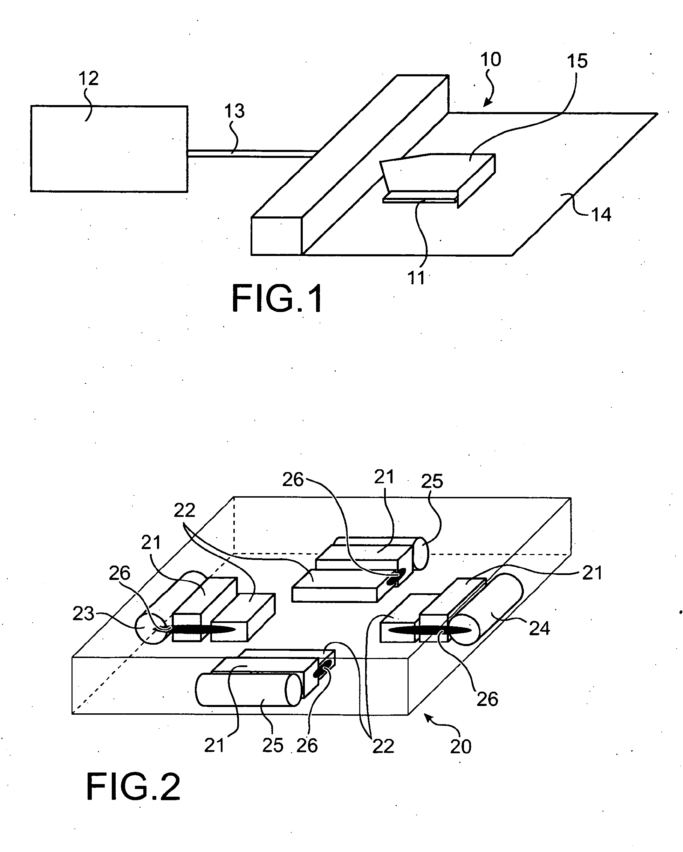

Un dispositif mettant en oeuvre le procédé de mesure de perméabilité de l'invention, illustré sur la figure 1, est un dispositif par perturbation de spire, dans un exemple d'instrumentation de mesure de perméabilité.

Ce dispositif comprend :

- une cellule de mesure 10 apte à recevoir un échantillon magnétique 11 selon l'invention,
- un analyseur de réseaux vectoriel 12, par exemple de type HP8753ES,

reliés entre eux par un câble hyperfréquence 13.

La cellule de mesure 10 comprend un plan de masse 14, associé à une spire de mesure 15.

Dans ce dispositif de mesure de perméabilité, on utilise un échantillon associé à une valeur de perméance ou de perméabilité que l'on doit retrouver en ajustant le coefficient correctif K. L'utilisation de cet échantillon selon l'invention permet de garantir la stabilité de mesure, cet échantillon étant bien caractérisé par la valeur qui lui est associée quelles que soient les conditions de l'environnement de mesure.

L'échantillon de l'invention est un échantillon de référence de perméabilité comprenant au moins une inclusion permettant de créer, dans un volume donné, une perméabilité artificielle locale. Chaque inclusion est réalisée par la combinaison d'au moins un composant inductif éventuellement associé à une combinaison d'au moins un composant capacitif, et/ou résistif, et/ou actif. La réponse en fréquence des propriétés électromagnétiques de chaque volume est ajustée une fois pour toutes par la valeur et l'architecture d'assemblage des composants.

La figure 2 illustre un exemple de réalisation de l'échantillon de référence suivant l'invention apte à être utilisé dans le système de mesure illustré sur la figure 1.

Cet échantillon 20 comprend les composants suivants :

- des capacités 21, par exemple de 0,5pF,

- des résistances 22, par exemple de 4,7KΩ,
- des inductances solénoïdes 23, par exemple de 47nH,
- des inductances solénoïdes 24, par exemple de 10nH,
- des inductances solénoïdes 25 non connectés, par exemple de 47nH et de 10nH,

certains de ces composants étant soudés en parallèle par des liaisons 26.

L'ensemble de ces composants est enrobé dans un pavé de résine 30, par exemple de 9x9x0,5mm$^3$.

La perméabilité de l'échantillon de l'invention peut être rendue variable. Dans ce cas, sans perturber le système de mesure, on obtient un échantillon de référence ajustable en faisant varier à distance la valeur d'un ou plusieurs composants de l'inclusion.

Dans une étape de pré-caractérisation la perméance apparente (produit de la perméabilité par le volume considéré) de l'échantillon de référence est mesurée une fois pour toutes à l'aide d'un dispositif de caractérisation validé par ailleurs.

Les propriétés de l'échantillon, par exemple sa perméance, sont stables dans le temps et permettent de valider les caractérisations ultérieures. Elles permettent ainsi de vérifier le calibrage de l'instrumentation en mesurant en conditions réelles un échantillon connu, et/ou la non dérive de l'instrumentation, et/ou la validité de la chaîne de calcul des propriétés du matériau.

A partir de la perméance, on peut calculer des valeurs intégrales (par exemple intégrale sur la fréquence de la perméance divisée par la fréquence, ou intégrale sur la fréquence de la perméance multipliée par la fréquence), qui peuvent être associées à l'échantillon de référence. L'utilisation de ces valeurs intégrales rend l'échantillon de référence moins sensible aux aléas de réalisation ou de caractérisation, et donc encore mieux adapté pour constituer une référence.

La stabilité des propriétés de chaque inclusion dans le temps est réalisée en vérifiant la stabilité dans le temps des composants de cette inclusion.

L'utilisation de composants dédiés pour l'électronique et de petites dimension permet de réaliser des échantillons de référence de petite taille facilement insérables dans les dispositifs de mesure.

L'utilisation d'éléments à fonction électrique, par exemple fils de cuivre, capacités..., permet par ailleurs :

- d'assurer l'insensibilité au champ magnétique du spectre de perméabilité créé ;
- de limiter les dérives de propriétés en supprimant les effets d'oxydation et vieillissement souvent propres aux matériaux magnétiques classiques ;
- de limiter les dérives en température non maîtrisés dans le cas des matériaux magnétiques classiques.

L'échantillon de référence de l'invention se différencie des métamatériaux, dans lesquels les inclusions sont constituées d'un élément inductif, assurant un couplage magnétique avec un champ extérieur, et d'une charge connectée à cet élément inductif. Ces métamatériaux contiennent des composants RLC, et sont caractérisés en terme de perméabilité (propriété homogénéisée). En effet dans l'échantillon de l'invention on associe à celui-ci une autre propriété qui est la perméance, qui est quasiment indépendante de la cellule de caractérisation. Il se différencie également des métamatériaux par le fait qu'il est positionné par rapport au moyen de caractérisation (dans la ligne ou la cellule de mesure, ...). La (ou les) inclusions le constituant doit être positionnée de façon reproductible dans la cellule de mesure. On peut associer à l'inclusion tout moyen de positionnement mécanique, passif ou actif, permettant de définir un volume, dans lequel la perméance est exprimée, qui peut être positionné de façon reproductible dans les moyens de caractérisation. Enfin, dans le cas de l'échantillon de référence de l'invention, on s'intéresse à la perméance, qui est une propriété locale.

De plus, la mise en forme de chaque volume correspondant à une inclusion peut être facilement assurée par l'utilisation ou non d'un matériau diélectrique de remplissage. Ainsi, l'inclusion peut ne pas remplir l'ensemble du volume correspondant. On recherche généralement à obtenir des tailles d'inclusions petites devant la cellule de caractérisation à laquelle est destiné l'échantillon de référence, en utilisant par exemple un motif inductif (par exemple deux à dix fois plus petit).

Avec une géométrie des inclusions adaptée, l'échantillon de référence selon l'invention peut présenter une fonction magnétique de référence dans une direction de champ électromagnétique (polarisation) et une fonction diélectrique non magnétique dans une autre direction. Cela permet de réaliser une mesure de référence avec un même échantillon dans le cas d'une technique de caractérisation différentielle de la perméabilité : dans une direction on ne mesure que les effets diélectriques et dans l'autre direction on mesure les effets diélectriques et magnétiques. Par différentiation, on peut alors obtenir les effets magnétiques.

L'échantillon de référence de l'invention se différencie des dispositifs de calibrage d'analyseurs de réseaux classiques. En effet ces dispositifs utilisent la connexion physique d'une impédance électronique de charge à la ligne de transmission, le couplage de cette impédance étant donc un couplage conduit. Par contre dans le cas de l'échantillon de référence de l'invention le couplage est un couplage par rayonnement sans connexion entre l'échantillon de référence et la structure de caractérisation, y compris en ligne de transmission.

Exemple de réalisation d'un échantillon de référence

Une technique de caractérisation de couches minces ferromagnétiques par perturbation de spire est décrite dans le document référencé [1]. Cette technique permet de déterminer le spectre de perméabilité magnétique d'une couche mince sous la forme d'un échantillon centimétrique. Elle repose sur une double mesure permettant de connaître la variation d'impédance d'une mono-spire que l'on vient charger par la couche mince magnétique à caractériser. Un calcul permet alors d'obtenir la perméabilité hyperfréquence de la couche mince.

Pour réaliser un échantillon de référence dans un faible volume, on utilise un circuit RLC parallèle résonant. L'inductance L fait office d'élément de couplage magnétique avec le champ électromagnétique incident sur l'inclusion. La structure RLC parallèle permet une compacité plus élevée de l'échantillon de référence par rapport à une structure RLC série, qui serait également possible.

En ajustant les valeurs de composants, on peut faire varier la fréquence de résonance et l'amplitude de la perméabilité apparente mesurée en ajustant les valeurs des composants. On utilise une modélisation de la réponse en perméabilité apparente de l'inclusion avec la formulation approchée suivante :

$$\mu_{eff} = 1 - \alpha \, \frac{Z_b}{Z_b + Z_c}$$

avec

- $\mu_{eff}$ : perméabilité apparente du volume défini autour de l'inclusion,
- $\alpha$ : coefficient de remplissage réel,
- $Z_b$ : impédance du composant inductif de couplage avec le champ excitateur dans la cellule de caractérisation,
- $Z_c$ : impédance de charge connectée en parallèle sur le composant inductif.

Dans le cas d'un circuit RLC parallèle, la fréquence de résonance théorique $F_{rth}$ de la perméabilité obtenue est décrite par la formule suivante:

$$F_{rth} = \frac{1}{2\pi\sqrt{LC}}$$

où L et C sont les valeurs de l'inductance et de la capacité totales parallèles de l'inclusion (respectivement en Henry et Farad).

Dans cet exemple des composants montés en surface, ou CMS, peuvent être connectés entre eux et reportés sur une plaquette de verre utilisée habituellement comme substrat pour les films ferromagnétiques caractérisés.

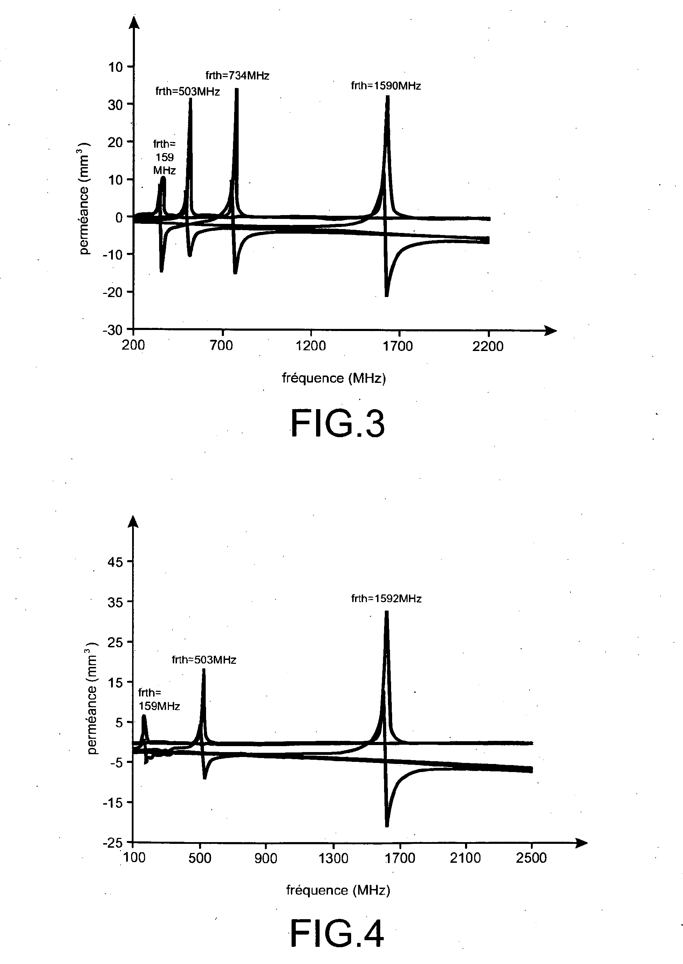

Les figures 3, 4, 5A et 5B illustrent des exemples de perméances mesurées par perturbation de spire en fonction des valeurs de composants utilisés pour la réalisation des échantillons de référence.

La figure 3 illustre des spectres de perméance obtenus avec ces échantillons de référence à partir de trois éléments R, L et C en parallèle tels que :

C=1pF
L=10nH→220nH
R=∞

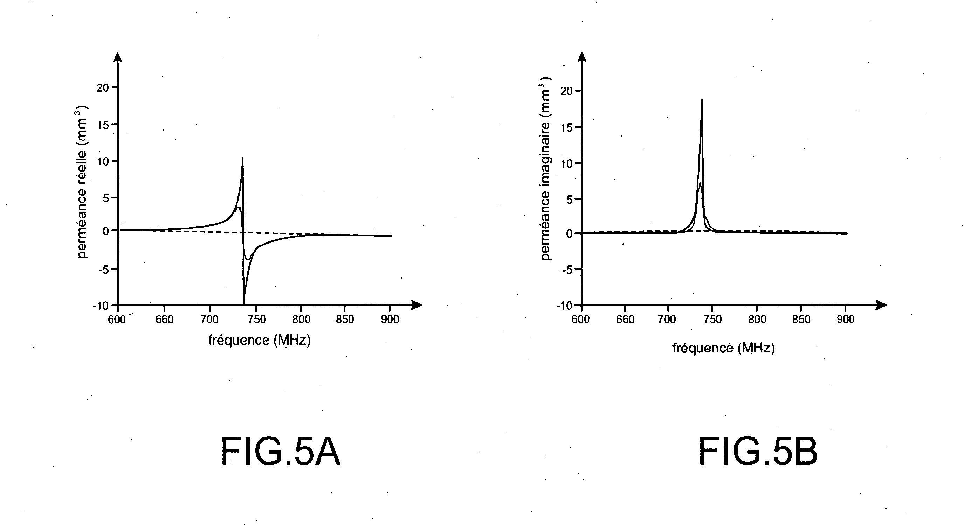

Les figures 5A et 5B illustrent des spectres de perméance obtenus avec des échantillons de référence à partir des trois éléments R, L et C en parallèle tels que :

C=1pF→100pF
L=10nH
R=∞

Les figures 5A et 5B illustrent des spectres de perméance avec un échantillon de référence constitué à partir de trois éléments R, L, C en parallèle, tels que :

L=47nH
C=1pF
R=∞, 100kΩ, 25kΩ, 5kΩ

Pour réaliser une mesure différentielle, on effectue les deux mesures nécessaires en assurant la rotation de 90° d'un échantillon de référence au sein de la cellule de mesure.

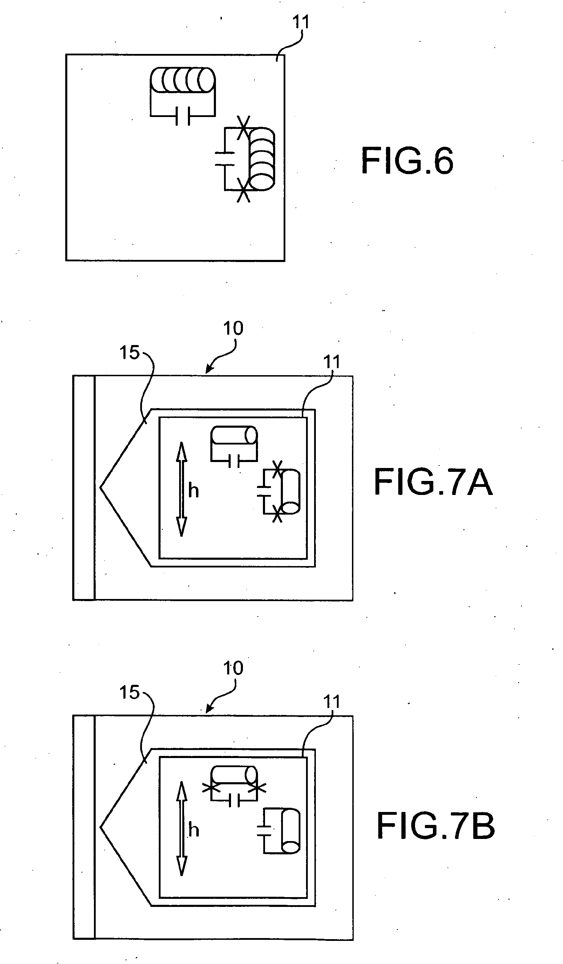

La figure 6 illustre le principe d'une réalisation de l'échantillon de référence magnétique avec une référence diélectrique intégrée. Les croix marquent les connections qui n'ont pas été réalisées entre les composants de l'inclusion. Une inclusion sur deux ne présente pas de perméabilité, même si ses propriétés électriques (permittivité) restent quasiment identiques. On dénomme cet échantillon «échantillon bipolarisé ».

Pour la mesure d'un tel échantillon, on procède en deux étapes telles qu'illustrées sur les figures 7A et 7B, en bénéficiant de la géométrie particulière quasi-TEM des champs électromagnétiques dans la cellule de caractérisation.

Sur la figure 7A, l'inclusion active (sans les croix) n'est pas excitée par le champ magnétique h car celui ci est perpendiculaire à l'axe dé la bobine. Celle qui est excitée par le champ magnétique h ne présente pas de perméabilité car les composants ne sont pas connectés. On mesure donc dans ce cas uniquement les effets diélectriques.

Sur la figure 7B, l'inclusion active est excitée par le champ magnétique h (champ parallèle à l'axe de la bobine); l'inclusion inactive n'est pas excitée. On mesure donc dans ce cas les effets de permittivité et perméabilité.

REFERENCES

[1] Article intitulé : "An improved permeameter for thin films measurements up to 6GHz" de D. Pain, M. Ledieu, O. Acher, A.L Adenot et F. Duverger (Journal of Applied Physics, volume 85(8), 15 avril 1999, pages 5151-5153)

[2] Article intitulé : "Cross measurements of thin film permeability up to UHF range" de M. Yamaguchi, O. Acher, Y.. Miyazawa, K.I. Arai et M. Ledieu (Journal of Magnetism and Magnetic Materials, 242-245, 2002, pages 970-972).

**Revendications**

1. Procédé de mesure de la perméabilité magnétique d'un matériau magnétique par mesure de l'interaction magnétique d'un champ électromagnétique avec ce matériau en utilisant un dispositif de mesure comportant une cellule de mesure reliée par un câble hyperfréquence (13) à un analyseur de réseau vectoriel (12), ledit procédé comprenant :

   - des étapes <u>préalables</u> d'étalonnage/calibrage dudit dispositif de mesure, de détermination de coefficients correctifs à appliquer aux mesures obtenues grâce à ce dispositif, et de vérification de la non-dérive de ce dispositif, ces étapes étant réalisées à l'aide d'un échantillon de référence,
   - <u>une étape de mesure de la perméabilité du matériau magnétique,</u>

   **caractérisé en ce que,** <u>pendant les étapes préalables</u>, on utilise un échantillon de référence comprenant au moins une inclusion permettant de créer, dans un volume donnée, une perméabilité artificielle locale, chaque inclusion étant réalisée par la combinaison d'au moins un composant inductif associé à une combinaison d'au moins un composant capacitif; et/ou résistif, et/ou actif, la réponse en fréquence des propriétés électromagnétiques de chaque volume étant ajustée par la valeur et l'architecture d'assemblage des composants, <u>et **en ce que** la valeur d'au moins un composant d'au moins une inclusion est ajustable à distance</u>.

2. Procédé selon la revendication 1, dans lequel l'échantillon de référence comporte au moins un élément contenant un matériau magnétique.

3. Procédé selon la revendication 2, dans lequel au moins un composant comprend des éléments à fonction électrique.

4. Procédé selon la revendication 1 ou 2, dans lequel les composants d'au moins une inclusion sont enrobés dans un matériau diélectrique de remplissage.

5. Procédé selon l'une des revendications 1 ou 2, dans lequel l'ensemble des inclusions est enrobé dans un matériau diélectrique de remplissage.

6. Procédé selon l'une des revendications 1 ou 2, pour lequel la forme de l'échantillon de référence permet un positionnement répétable et facile dans une cellule de mesure.

7. Procédé selon la revendication 1, dans lequel l'échantillon de référence présente une fonction magnétique de référence dans une direction de champ électromagnétique, et une fonction diélectrique non magnétique dans une autre direction.

8. Echantillon de référence de perméabilité apte à être utilisé pour des étapes :

   - d'étalonnage/calibrage d'un dispositif de mesure de la perméabilité magnétique d'un matériau magnétique par mesure de l'interaction magnétique d'un champ électromagnétique avec ce matériau, ce dispositif de mesure comportant une cellule de mesure reliée par un câble hyperfréquence (13) à un analyseur de réseau vectoriel (12),
   - de détermination des coefficients correctifs à appliquer aux mesures obtenues grâce à ce dispositif,
   - de vérification de la non-dérive de ce dispositif,

   **caractérisé en ce qu'**il comprend au moins une inclusion permettant de créer, dans un volume donné, une perméabilité artificielle locale, chaque inclusion étant réalisée par la combinaison d'au moins un composant inductif associé à une combinaison d'au moins un composant capacitif, et/ou résistif, et/ou actif, la réponse en fréquence des propriétés électromagnétiques de chaque volume étant ajustée par la valeur et l'architecture d'assemblage des composants, <u>et **en ce que** la valeur d'au moins un composant d'au moins une inclusion est ajustable à distance.</u>

9. Echantillon selon la revendication 8, qui comporte au moins un élément contenant un matériau magnétique.

10. Echantillon selon la revendication 8, dans lequel au moins un composant comprend des éléments à fonction électrique.

11. Echantillon selon l'une des revendications 8 ou 9, dans lequel les composants d'au moins une inclusion sont enrobés dans un matériau diélectrique de remplissage.

12. Echantillon selon l'une des revendications 8 ou 9, dans lequel l'ensemble des inclusions est enrobé dans un matériau diélectrique de remplissage.

13. Echantillon selon l'une des revendications 8 ou 9, dont la forme permet un positionnement répétable et facile dans une cellule de mesure.

14. Echantillon selon la revendication 8, qui présente une fonction magnétique de référence dans une direction de champ électromagnétique, et une fonction diélectrique non magnétique dans une autre direction.

**Claims**

1. Method to measure the magnetic permeability of a magnetic material by measuring the magnetic interaction of an electromagnetic field with this material using a measuring device comprising a measuring cell linked via a microwave frequency cable (13) to a vector network analyzer (12), said method comprising:

   - prior steps of gauging / calibrating said measuring device, of determining corrective coefficients to be applied to the measurements obtained with this device, and of verifying the non-drift of this device, these steps being performed with the aid of a reference sample,
   - a step to measure the permeability of the magnetic material,

   **characterized in that,** during the prior steps, a reference sample is used comprising at least one inclusion which, in a given volume, allows local artificial permeability to be created, each inclusion being produced by combining at least one inductive component associated with a combination of at least one capacitive and / or resistive and / or active component, the frequency response of the electromagnetic properties of each volume being adjusted by the value and assembly architecture of the components, and **in that** the value of at least one component of at least one inclusion can be remotely adjusted.

2. Method according to claim 1, wherein the reference sample comprises at least one element containing a magnetic material.

3. Method according to claim 2, wherein at least one component comprises elements having an electric function.

4. Method according to claim 1 or 2, wherein the components of at least one inclusion are coated with a dielectric filler material.

5. Method according to either of claims 1 or 2, wherein all the inclusions are coated with a dielectric filler material.

6. Method according to either of claims 1 or 2, for which the shape of the reference sample allows easy, repeatable positioning in a measuring cell.

7. Method according to claim 1, wherein the reference sample has a reference magnetic function in an electromagnetic field direction, and a non-magnetic dielectric function in another direction.

8. Reference permeability sample able to be used for the steps of:

   - gauging / calibrating a device to measure the magnetic permeability of a magnetic material by measuring the magnetic interaction of an electromagnetic field with this material, this measuring device comprising a measuring cell linked via a microwave frequency cable (13) to a vector network analyzer (12),
   - determining corrective coefficients to be applied to the measurements obtained using this device,
   - verifying the non-drift of this device,

   **characterized in that** it comprises at least one inclusion which, in a given volume, allows local artificial permeability to be created, each inclusion being produced by combining at least one inductive component associated with a combination of at least one capacitive and / or resistive and / or active component, the frequency response of the electromagnetic properties of each volume being adjusted by the value and assembly architecture of the components, and **in that** the value of at least one component of at least one inclusion can be remotely adjusted.

9. Sample according to claim 8, which comprises at least one element containing a magnetic material.

10. Sample according to claim 8, wherein at least one component comprises elements having an electric function.

11. Sample according to either of claims 8 or 9, wherein the components of at least one inclusion are coated with a dielectric filler material.

12. Sample according to either of claims 8 or 9, wherein all the inclusions are coated with a dielectric filler material.

**13.** Sample according to either of claims 8 or 9, whose shape allows easy, repeatable positioning in a measuring cell.

**14.** Sample according to claim 8, which has a reference magnetic function in an electromagnetic field direction, and a dielectric non-magnetic function in another direction.

**Patentansprüche**

**1.** Verfahren zur Messung der magnetischen Permeabilität eines magnetischen Materials durch Messung der magnetischen Wechselwirkung eines elektromagnetischen Feldes mit diesem Material, indem man eine Messvorrichtung mit einer Messzelle benutzt, die durch ein Hyper- bzw. Höchstfrequenzkabel (13) mit einem vektoriellen Netzanalysator (12) verbunden ist, wobei das genannte Verfahren umfasst:

- Vorausschritte zur Eichung/Kalibrierung der genannten Messvorrichtung, zur Bestimmung von Korrekturkoeffizienten, anzuwenden auf die dank dieser Vorrichtung erhaltenen Messungen, und zur Verifizierung der Nicht-Abweichung dieser Vorrichtung, wobei diese Schritte mit Hilfe eines Referenzmusters realisiert werden,
- einen Schritt zur Messung der Permeabilität des magnetischen Materials,

**dadurch gekennzeichnet, dass** man während der Vorausschritte ein Referenzmuster benutzt, das wenigstens eine Inklusion enthält, die ermöglicht, in einem gegebenen Volumen eine lokale künstliche Permeabilität zu erzeugen, wobei jede Inklusion realisiert wird durch die Kombination von wenigstens einer induktiven Komponente, verbunden mit einer Kombination von wenigstens einer kapazitiven und/oder resistiven und/oder aktiven Komponente, wobei die Frequenzreaktion der elektromagnetischen Eigenschaften jedes Volumens durch den Wert und die Zusammenbauarchitektur der Komponenten justiert wird, und **dadurch**, dass der Wert wenigstens einer Komponenten wenigstens einer Inklusion fernjustierbar ist.

**2.** Verfahren nach Anschluss 1, bei dem das Referenzmuster wenigstens ein ein magnetisches Material enthaltendes Element umfasst.

**3.** Verfahren nach Anspruch 2, bei dem wenigstens eine Komponente Elemente mit elektrischer Funktion umfasst.

**4.** Verfahren nach Anspruch 1 oder 2, bei dem die Komponenten von wenigstens einer Inklusion in ein dielektrisches Füllmaterial eingebettet sind.

**5.** Verfahren nach einem der Ansprüche 1 oder 2, bei dem die Gesamtheit der Inklusionen in ein dielektrisches Füllmaterial eingebettet ist.

**6.** Verfahren nach einem der Ansprüche 1 oder 2, bei dem die Form des Referenzmusters eine wiederholbare und leichte Positionierung in einer Messzelle ermöglicht.

**7.** Verfahren nach Anspruch 1, bei dem das Referenzmuster in einer Richtung eine magnetische Referenzfunktion eines elektromagnetischen Feldes aufweist und in einer anderen Richtung eine dielektrische nicht-magnetische Funktion.

**8.** Permeabilitäts-Referenzmuster, verwendbar für Schritte:

- zur Eichung/Kalibrierung einer Messvorrichtung der magnetischen Permeabilität eines magnetischen Materials durch Messung der magnetischen Wechselwirkung eines elektromagnetischen Feldes mit diesem Material, wobei diese Messvorrichtung eine Messzelle umfasst, die durch ein Hyper- bzw. Höchstfrequenzkabel (13) mit einem vektoriellen Netzanalysator (12) verbunden ist,
- zur Bestimmung der auf die dank dieser Vorrichtung erhaltenen Messungen anzuwendenden Korrektorkoeffizienten,
- zur Verifizierung der Nicht-Abweichung dieser Vorrichtung,

**dadurch gekennzeichnet, dass** es wenigstens eine Inklusion enthält, die ermöglicht, in einem gegebenen Volumen eine lokale künstliche Permeabilität zu erzeugen, wobei jede Inklusion realisiert wird durch die Kombination von wenigstens einer induktiven Komponente, verbunden mit einer Kombination von wenigstens einer kapazitiven und/oder resistiven und/oder aktiven Komponente, wobei die Frequenzreaktion der elektromagnetischen Eigenschaften jedes Volumens durch den Wert und die Zusammenbauarchitektur der Komponenten justiert wird, und **dadurch**, dass der Wert wenigstens einer Komponenten wenigstens einer Inklusion fernjustierbar ist.

**9.** Muster nach Anspruch 8, das wenigstens ein ein magnetisches Material enthaltendes Element umfasst.

**10.** Muster nach Anspruch 8, bei dem wenigstens eine Komponente Elemente mit elektrischer Funktion umfasst.

**11.** Muster nach einem der Ansprüche 8 oder 9, bei dem die Komponenten wenigstens einer Inklusion in ein dielektrisches Füllmaterial eingebettet sind.

**12.** Muster nach einem der Ansprüche 8 oder 9, bei dem die Gesamtheit der Inklusionen in ein dielektrisches Füllmaterial eingebettet ist.

**13.** Muster nach einem der Ansprüche 8 oder 9, bei dem die Form eine wiederholbare und leichte Positionierung in einer Messzelle ermöglicht.

**14.** Muster nach Anspruch 8, das in einer Richtung eine magnetische Referenzfunktion eines elektromagnetischen Feldes aufweist und in einer anderen Richtung eine dielektrische nicht-magnetische Funktion.

FIG.1

FIG.2

FIG.3

FIG.4

FIG.5A

FIG.5B

FIG.6

FIG.7A

FIG.7B

## RÉFÉRENCES CITÉES DANS LA DESCRIPTION

**Documents brevets cités dans la description**

- FR 2822957 A

- US 6351119 B1

**Littérature non-brevet citée dans la description**

- New achievements in high-frequency permeability measurements of magnetic materials. **LEDIEU M et al.** JOURNAL OF MAGNETISM AND MAGNETIC MATERIALS. ELSEVIER, Mars 2003, vol. 258-259, 144-150
- Influence of the electrical resistivity of a ferromagnetic thin film on its permeability measurement performed with a permeameter. **JACQUART P-M et al.** JOURNAL OF MAGNETISM AND MAGNETIC MATERIALS. ELSEVIER SCIENCE PUBLISHERS, Octobre 2004, vol. 281, 82-91

- **D. PAIN ; M. LEDIEU ; O. ACHER ; A.L ADENOT ; F. DUVERGER.** An improved permeameter for thin films measurements up to 6GHz. *Journal of Applied Physics,* 15 Avril 1999, vol. 85 (8), 5151-5153
- **M. YAMAGUCHI ; O. ACHER ; Y.. MIYAZAWA ; K.I. ARAI ; M. LEDIEU.** Cross measurements of thin film permeability up to UHF range. *Journal of Magnetism and Magnetic Materials,* 2002, vol. 242-245, 970-972